# EUROPEAN PATENT APPLICATION

(11) **EP 0 698 923 A1**
(43) Date of publication of application: **28.02.1996**
(21) Application number: 95305535.7
(22) Date of filing: 08.08.1995
(51) Int. Cl.: H01L 27/08

(54) **Semiconductor integrated circuit**

(30) Priority: 19.08.1994 JP 195758/94; 11.05.1995 JP 113446/95
(71) Applicant: SEIKO INSTRUMENTS INC., Chiba-shi, Chiba 261 (JP)
(72) Inventor: Harada, Hirofumi, Mihama-ku, Chiba-shi, Chiba (JP); Osanai, Jun, Mihama-ku, Chiba-shi, Chiba (JP); Kojima, Yoshikazu, Mihama-ku, Chiba-shi, Chiba (JP)
(74) Representative: Sturt, Clifford Mark

(57) **Abstract**

A semiconductor integrated circuit is disclosed which comprises two polycrystal silicon films which are electrically connected at overlapping portions. In one embodiment of the invention the integrated circuit is a ladder resistor circuit. A ladder resistor circuit comprises a first resistor constituted by a first polycrystal silicon film deposited upon a surface of a substrate and a second resistor constituted by a second polycrystal silicon film electrically separated from the first resistor by an insulating film. Further, in a semiconductor integrated circuit including a ladder resistor circuit and a field-effect transistor, a gate electrode of the field-effect transistor is formed by the first polycrystal silicon film or the second polycrystal silicon film.

## Description

The present invention relates to a semiconductor integrated circuit. In particular, it relates to a circuit comprising multi-layered polycrystal silicon films which may, for example, constitute elements of any one or more of a resistor circuit, a transistor and a condenser.

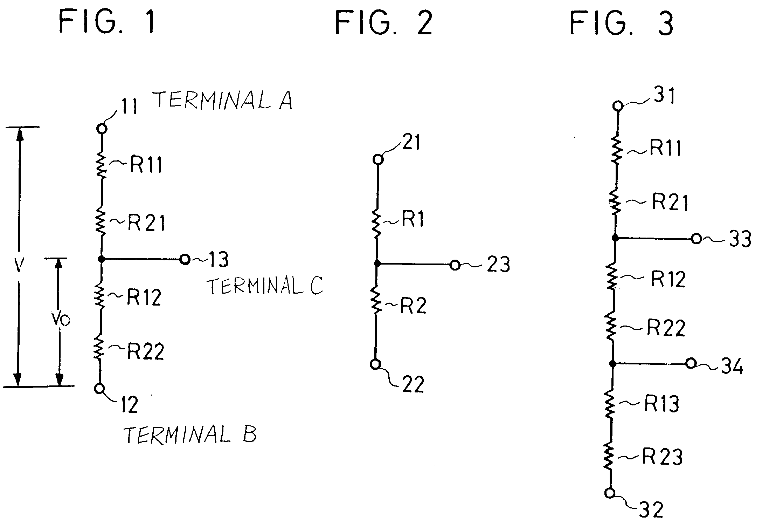

Semiconductor integrated circuits are known which comprise a single layer of polycrystal silicon film. For example, Figure 2 of the accompanying drawings shows a resistor circuit which is utilised in the semiconductor integrated circuit for a power supply or the like. To obtain a divided voltage of a voltage across a first terminal 21 and a second terminal 22 from a terminal 23, a resistor R1 and a resistor R2 are patterned in a polycrystal silicon film in lengths corresponding to a voltage ratio thereby providing the divided voltage.

However, such circuits which comprise a single layer of polycrystal silicon film are generally large, and hence expensive. With regard to the specific example of the aforementioned resistor circuit, this problem is further increased for the following reasons.
1. It is necessary to extend the length of the resistor in proportion to an increase in its resistance value. Therefore, when a circuit is designed with an increase in resistance value, its chip size is enlarged and the cost of the circuit is increased. Hence, an inexpensive circuit cannot be provided.
2. When a gate electrode of a field effect transistor and a thin film of a ladder resistor formed on the same substrate are formed to combine together, the area of the ladder resistor is enlarged, thereby similarly increasing the cost.

It is an object of the present invention to provide a semiconductor integrated circuit which is reduced in size and thus in cost. It is another object of the present invention to increase the resistance value per unit area of a resistor circuit. It is a further object of the present invention to provide an integrated circuit comprising a resistor with an increased resistance value per unit area and a transistor and/or condenser. It is yet another object of the present invention to provide a semiconductor integrated circuit with a power supply in the form of a voltage detector of reduced size.

According to one aspect of the present invention there is provided a semiconductor integrated circuit comprising: a polycrystal silicon film on a substrate; an insulating film on the first polycrystal silicon film; and a further polycrystal silicon film on the insulating film; characterised in that at least a portion of the polycrystal silicon films overlap and in that the opposing portions are electrically connected.

The polycrystal silicon films may be connected either directly or by electrically conductive wiring.

The semiconductor integrated circuit may comprise a voltage divider circuit. Such a voltage divider circuit may comprise two resistors constituted by respective polycrystal silicon films. The output of the circuit is provided where the polycrystal silicon films constituting the two resistors overlap.

Alternatively, the voltage divider circuit may comprise more than two resistors. In particular, it may comprise four or more resistors, two or more on each film. Alternate resistors may be constituted by alternate polycrystal silicon films and output divided voltages provided at every second overlap between the films constituting the resistors.

The voltage divider circuit may constitute a ladder resistor circuit.

The semiconductor integrated circuit may comprise a field effect transistor, the gate electrode of which is constituted by one of the polycrystal silicon films. Similarly, the circuit may further comprise a condenser, an electrode of which is constituted by one of the polycrystal silicon films.

Further, the semiconductor integrated circuit may be a voltage detector. In this event, it may comprise a voltage divider according to the present invention, a reference voltage circuit, a voltage comparison circuit for comparing the reference voltage output from the reference voltage circuit and a divided voltage output from the voltage divider circuit and an output circuit for outputting a signal indicative of the comparison.

According to another aspect of the present invention there is provided a semiconductor integrated circuit comprising: a first polycrystal silicon film provided on a surface of a substrate; an insulating film provided on the first polycrystal silicon film; and a second polycrystal silicon film provided on the insulating film; wherein the first and second polycrystal silicon films respectively have portions overlapping each other in view from a plane and the first polycrystal silicon film is electrically connected to the second polycrystal film through contact hole portions provided in the insulating layer between the overlapped portions.

Via hole portions may be formed in places of the contact hole portions. Alternatively, the first polycrystal silicon film may be directly connected to the second polycrystal silicon film in place of the contact hole portions.

The semiconductor integrated circuit device may further comprise a resistor circuit in which resistors are constituted between a first terminal and a second terminal, a third terminal is taken out from between the first and second terminals and a voltage applied between the first and second terminals is divided and output from the third terminal. The first terminal is electrically connected to either one of the first and second polycrystal silicon films, the second terminal is electrically connected to either one of the first and second polycrystal silicon films, the resistors are constituted by the first polycrystal silicon film and the second polycrystal silicon film and the contact hole portions are constituted between the first terminal and the second terminal. The third terminal is electrically connected to the contact hole portions.

The first resistor may comprise the first and second polycrystal silicon films, the second resistor may comprise the first and second polycrystal silicon films, a first contact hole portion may be constituted between the first and third terminals and a second contact hole portion may be constituted between the second and third terminals.

The semiconductor integrated circuit device may further comprise a field effect transistor and/or a condenser.

The resistor circuit may constitute a ladder resistor circuit.

According to a further aspect of the present invention there is provided a semiconductor integrated circuit device further comprising a reference voltage circuit, a voltage division circuit, a voltage comparison circuit and an output circuit, wherein at least two voltages from the reference voltage circuit and the voltage division circuit are input to the voltage comparison circuit and compared with each other, a signal in correspondence with a difference between the two voltages is output to the output circuit and the voltage division circuit constitutes a ladder resistance circuit.

Preferred embodiments of the present invention are outlined below.
1. A semiconductor integrated circuit including a field effect transistor utilising either one of a first layer of a polycrystal silicon film formed on a surface of a substrate and a second layer of a polycrystal silicon film formed contiguous to the first layer of the polycrystal silicon film via an interlayer insulating film as a gate electrode, a condenser utilising either one of the first layer of the polycrystal silicon film and the second layer of the polycrystal silicon film as an electrode and a ladder resistor circuit constituted by a first resistor comprising the first layer of the polycrystal silicon film and a second resistor comprising the second layer of the polycrystal silicon film wherein contact holes for electrically connecting the field-effect transistor to the resistor or the resistor to the condenser or the condenser to the field-effect transistor are formed spanning over the first layer of the polycrystal silicon film and the second layer of the polycrystal silicon film.
(2) A semiconductor integrated circuit including a ladder resistor circuit constituted by a first resistor comprising a first layer of a polycrystal silicon film and a second resistor comprising a second layer of a polycrystal silicon film contiguous to the first resistor via an insulating film wherein contact holes for electrically connecting the first resistor and the second resistor are formed spanning over the first layer of the polycrystal silicon film and the second layer of the polycrystal silicon film.
(3) A semiconductor integrated circuit wherein via holes are formed at the interlayer insulating film and the above-mentioned first layer of the polycrystal silicon film is directly connected to the second layer of the polycrystal silicon film therethrough.
(4) A semiconductor integrated circuit wherein via holes are formed at the interlayer insulating film and the above-mentioned first resistor is directly connected to the second resistor therethrough.

The ladder resistor circuit is formed by the polycrystal silicon film having a multi-layered structure and therefore, it is not necessary to provide respective intervals between the resistors by which the area can be reduced.

Further, the reduction of cost by the reduction of the chip area can be achieved by reducing the area of the contact portions required for connecting the first polycrystal silicon to the second polycrystal silicon.

Embodiments of the present invention will now be described with reference to the accompanying drawings, of which:
Fig. 1 is a circuit diagram of a ladder resistor circuit according to the present invention;
Fig. 2 is a circuit diagram of a conventional ladder resistor circuit;
Fig. 3 is a circuit diagram of another embodiment of a ladder resistor circuit according to the present invention;
Fig. 4 is a sectional view of a ladder resistor circuit according to the present invention;
Figs. 5A and 5B illustrate circuit diagrams of a ladder resistor circuit of another embodiment according to the present invention;
Figs. 6A and 6B illustrate a plane view and a sectional view of a contact portion of resistors in a ladder resistor circuit according to the present invention;
Figs. 7A and 7B illustrate a plane view and a sectional view of another embodiment of a contact portion of resistors in a ladder resistor circuit according to the present invention;
Fig. 8 is a plane view of contact portions of a gate electrode and a condenser electrode according to the present invention;
Figs. 9A and 9B illustrate a plane view and a sectional view of another embodiment of a contact portion of resistors in a conventional ladder resistor circuit;
Fig. 10 is a circuit block diagram of a voltage detector which is one of semiconductor integrated circuits to which the present invention is applicable;
Fig. 11 is a circuit diagram of a voltage division circuit in a voltage detector which is one of semiconductor integrated circuits to which the present invention is applicable; and
Fig. 12 is a sectional view of a substrate in the case where the present invention is applied to an integrated circuit including a field-effect transistor and a condenser.

Fig. 1 is a circuit diagram of a ladder resistor circuit according to the present invention. A divided voltage V0 is provided from a terminal C 13 by dividing a voltage V applied across a terminal A 11 and a terminal B 12 by respective resistors R11, R21, R12 and R22. The resistors R11 and R12 are formed by a first layer of a polycrystal silicon film. The resistors R21 and R22 are formed by a second layer of a polycrystal silicon film.
The resistances (R11+R21) and (R12+R22) providing the divided voltage are respectively constituted by summations each of a resistance of the first layer of the polycrystal silicon film and a resistance of the second layer of the polycrystal silicon film.

Accordingly, a desired divided voltage can be provided even if the specific resistance of the first layer of the polycrystal silicon film is not equal to that of the second layer of the polycrystal silicon film in manufacturing them.

Fig. 3 is a circuit diagram of another embodiment of a ladder resistor circuit providing two divided voltages. This is a circuit to obtain divided voltages from contact points of a terminal 33 and a terminal 34 from a voltage applied across a terminal 31 and a terminal 32. Resistances (R11+R21), (R12+R22) and (R13+R23) providing the divided voltages are constituted by resistances (R11, R12, R13) of a first polycrystal silicon film and resistances (R21, R22, R23) of a second polycrystal silicon film respectively having the same ratio. That is, the following equations are satisfied.
R11+R21:R12+R22:R13+R23 = R11:R12:R13 = R21:R22:R23

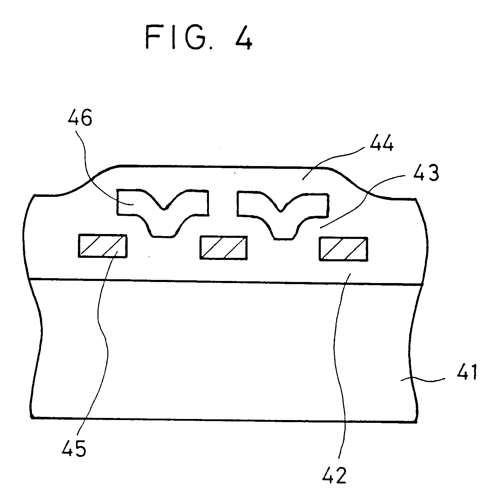

Fig. 4 is a view showing a sectional structure in the case where resistors are formed by two layers of polycrystal silicon films. A first layer of a resistor 45 is formed above a substrate 41 via a field insulating film 42. Further, an interlayer insulating film 43 is formed on the first layer of the resistor 45. A second layer of a resistor 46 according to the present invention is formed thereon. As shown in Fig. 4, portions or totals of the first layer of the resistor 45 and the second layer of the resistor 46 overlap. It is easy for designing to form the first layer of the resistor 45 and the second layer of the resistor 46 with an equal specific resistance.

However, they are basically formed by separate polycrystal silicon films and therefore, separate film thicknesses and specific resistances can be set. For example, the first layer of the resistor 45 may be formed by the same process as that of a gate electrode of a field-effect transistor formed in an IC and the second layer of the resistor 46 may be a polycrystal silicon film having a very thin film thickness compared with that of the first layer. For example, it is possible to optimize the film thickness of the first layer of the resistor as 200 through 400nm and that of the second layer as 10 through 50nm.

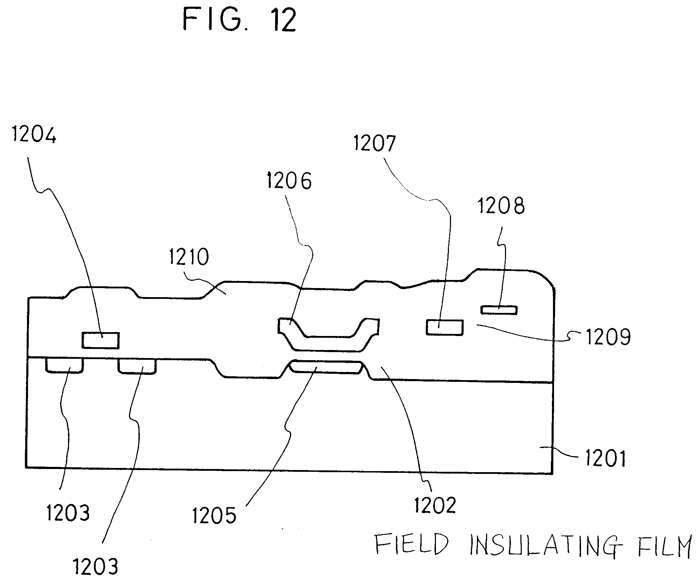

Fig. 12 is a sectional diagram of a substrate in case where the present invention is applied to an integrated circuit device including a field-effect transistor and a condenser. A first resistor 1207 comprising a first polycrystal silicon (film) and a second resistor 1208 comprising a second polycrystal silicon (film) of the present invention may be constituted above a silicon substrate 1201 interposing an interlayer insulating film 1209 and a field-effect transistor constituted by a gate electrode 1204 comprising the first polycrystal silicon (film) and a source/drain region 1203 formed in the silicon substrate, a condenser having a condenser electrode 1206 comprising the first polycrystal silicon (film) and a substrate side diffusion condenser electrode 1205 both of which are electrically separated by an insulating film 1210 and the like can be formed in a same process by also using the polycrystal silicon. In Fig. 12, the thickness of the second polycrystal silicon film may be thinner than that of the first polycrystal silicon film and their resistance values can arbitrarily be prescribed by the film thicknesses of the polycrystal silicon (films).

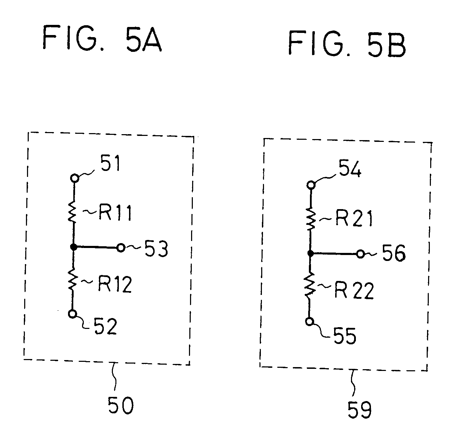

Figs. 5A and 5B are circuit diagrams of another embodiment wherein separate ladder resistor circuits are formed by separate polycrystal silicon films.

Resistors R11 and R12 of a ladder circuit block 50 of Fig. 5A are formed by a first layer of a polycrystal silicon film. Resistors R21 and R22 of a ladder circuit block 59 of Fig. 5B are formed by a second layer of a polycrystal silicon film. In case of Figs. 5A and 5B, the ladder resistors are separately formed in the circuits and therefore, their resistance ratios are separately set. A resistor film having a high resistance is employed in a ladder resistor net in which it is highly necessary to reduce current consumption of the ladder resistor.

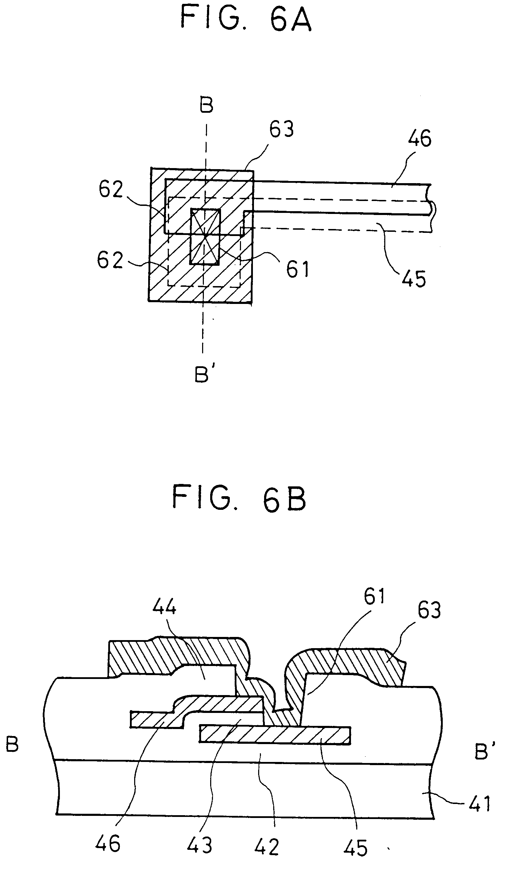

Figs. 6A and 6B illustrate a plane view and a sectional view of a contact portion of the above-mentioned ladder resistor circuit for electrically connecting the first layer of the polycrystal silicon (film) to the second layer thereof. The resistor 45 using the first layer of the polycrystal silicon (film) is electrically connected to the resistor 46 using the second layer of the polycrystal silicon (film) via a metallic wiring 63 of aluminum or the like. The resistor 45 and the resistor 46 overlap each other interposing an interlayer insulating film 43 at their end portions of the resistors and a contact hole 61 is formed from above the overlapped portions of end portions 62 of the respective polycrystal silicon (films).

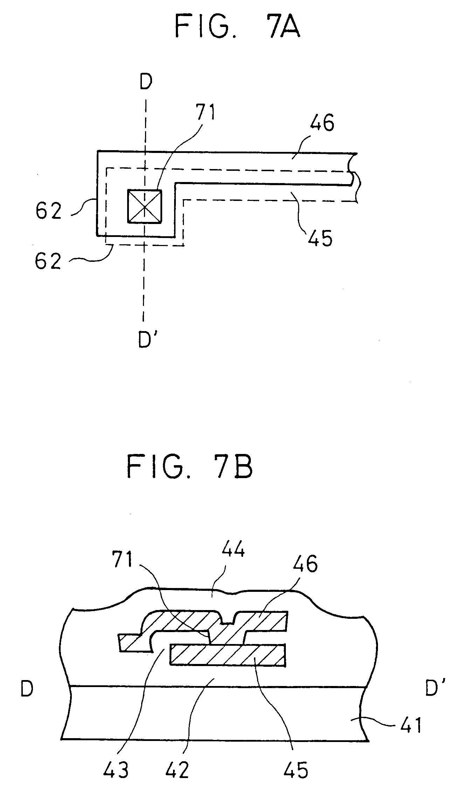

Or, another contact method of the first layer and the second layer polycrystal silicon (films) may be as shown in Fig. 7A and 7B. In Figs. 7A and 7B, a via hole 71 is formed at the interlayer insulating film 43 between the first and the second polycrystal silicon (films) and the first and the second polycrystal silicon (films) are directly connected to each other.

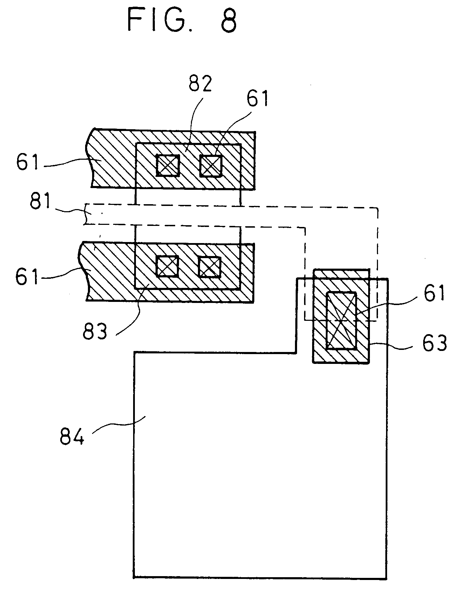

These contact methods are not restricted to connecting portions of resistors in a ladder resistor circuit or the like. For example, they are applicable to an electric connection between a gate electrode 82 of a field-effect transistor and a condenser electrode 84 as shown in Fig. 8. That is, these contact methods are applicable to all the portions in which the first layer of the polycrystal silicon (film) and the second layer of the polycrystal silicon (film) are to be electrically connected.

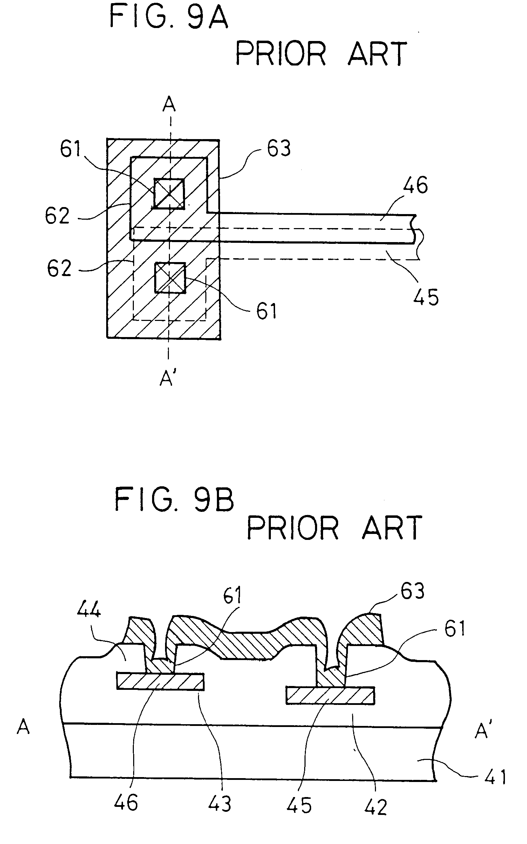

In the meantime, a conventional case as shown in Figs. 9A and 9B has been known in connecting the first and the second polycrystal silicon (film) in a ladder resistor circuit in which the two layers of the polycrystal silicon (films) are utilized as resistors. One contact hole 61 is provided for each of the end portions 62 of the first and the second polycrystal silicons forming the resistors and the two contact holes are connected by the metallic wiring 63 made of aluminum or the like. In this case, it is necessary to provide each of the end portions of the polycrystal silicon (films) with an area larger than that of the contact hole in consideration of a deviation in alignment. That is, the end portion of the polycrystal silicon (film) is spaced apart from the end portion of the contact hole by a certain distance as a margin in consideration of the deviation in alignment. Therefore, the area for each of the two contact portions of the polycrystal silicon (films) needs to be an area twice as much as that of each of the end portions of the polycrystal silicon (films).

However, in the former two contact methods, it is possible for the area necessary for the contact hole to eliminate a portion thereof in the margin for the contact portion of each of the end portions of the two polycrystal silicon (films) provided in consideration of the deviation in alignment. Therefore, when a number of such contact portions are present in a single circuit, the degree of reduction in a chip area is more enhanced than that of the latter with an increase in the number.

The above-mentioned ladder resistor circuit, and the ladder resistor circuit and the polycrystal silicon resistors constituting the circuit are utilized in various semiconductor integrated circuits.

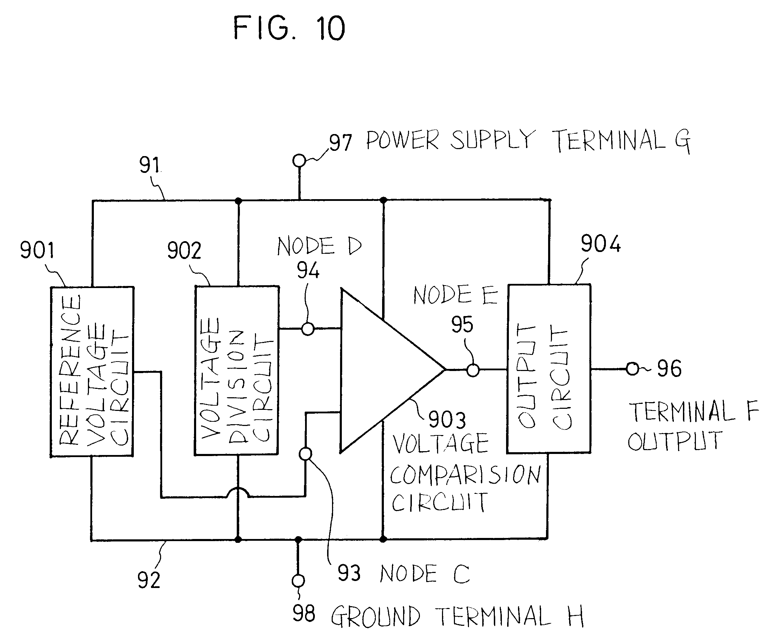

Fig. 10 shows a circuit block diagram of a voltage detector which is one of semiconductor integrated circuits for a power supply, as an example. The voltage detector comprises a reference voltage circuit 901, a voltage division circuit 902, a voltage comparision circuit 903 and an output circuit 904.

The reference voltage circuit 901 is connected between a power supply line 91 and a ground line 92 and has a function of outputting a constant voltage to a contact node C 93.

The voltage division circuit 902 is constituted by a plurality of series resistors connected between the power supply line 91 and the ground line 92 and has a function of dividing the power supply voltage with a connecting node D 94 as the start point.

The voltage comparision circuit 903 is connected between the power supply line 91 and the ground line 92, connected to the reference voltage circuit 901 at the contact node C 93, connected to the voltage division circuit 902 at the contact node D 94 and has a function of outputting a constant voltage to a contact node E 95 when the voltage of the contact node D 94 is below the voltage at the contact node C 93 wherein a difference between the voltages at the contact node C 93 and at the contact node D94 is used as an input.

The output circuit 904 is connected between the power supply line 91 and the ground line 92 and has a function of outputting a voltage to an output terminal F 96 by receiving the output from the voltage comparision circuit 903 at the contact node E 95.

The voltage detector has a function of rendering the output voltage 0 V when the power supply voltage is not larger than a detected voltage (for example, not larger than 0.8 V).

The detected voltage is determined by a reference voltage that is the output voltage of the reference voltage circuit 901 and a ratio of resistances of high resistance polycrystal silicon (films) constituting the voltage division circuit 902 and is devised to provide a desired detected voltage by polycrystal silicon fuses.

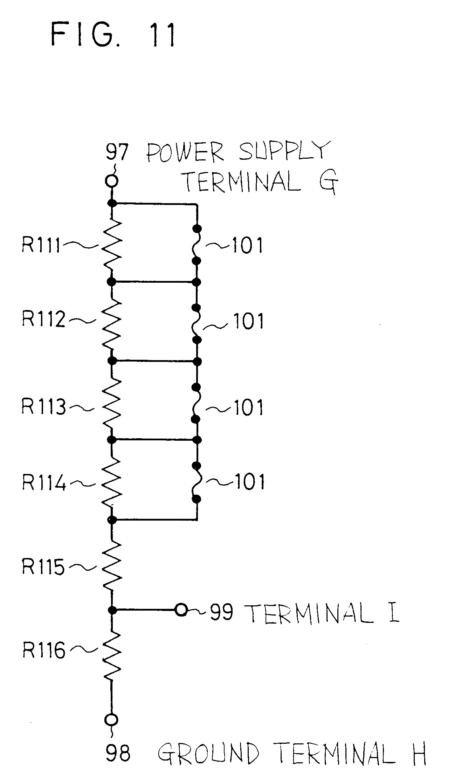

Fig. 11 shows an example of a voltage division circuit. The voltage division circuit is constituted by a ladder resistor circuit comprising polycrystal silicon resistors R111 through R116 having high resistance and polycrystal silicon fuses 101 having low resistance and has a function of dividing the power supply voltage by a ratio of resistances of the polycrystal silicon resistors and outputting it. In the ladder resistor circuit used here, a unit is formed by one polycrystal silicon resistor and one polycrystal silicon fuse connected in parallel, a plurality of the units are connected in series and its resistance value is changed by disconnecting the polycrystal silicon fuses. Thereby, a desired divided voltage can be provided from a terminal I 99.

As stated above, the high resistance polycrystal silicon (films) are indispensable elements in a semiconductor integrated circuit for a power supply and the effect received from the present invention is considerable.

According to the present invention, a ladder resistor having a large resistance value can be achieved whilst only covering a small area. Further, a gate electrode of a field-effect transistor and an electrode of a condenser can be formed easily on the same substrate during the same process.

The aforegoing description has been given by way of example only and it will be appreciated by a person skilled in the art that modifications can be made without departing from the scope of the present invention.

## Claims

1. A semiconductor integrated circuit comprising:
a polycrystal silicon film (45) on a substrate (41);
an insulating film (43) on the first polycrystal silicon film (45); and
a further polycrystal silicon film (46) on the insulating film (43);
characterised in that at least a portion (62) of the polycrystal silicon films (45, 46) overlap and in that the opposing portions are electrically connected.

2. A circuit as claimed in claim 1, characterised in that the polycrystal silicon films (45, 46) are connected by electrically conductive wiring (63).

3. A circuit as claimed in claim 1, characterised in that the polycrystal silicon films (45, 46) are directly connected.

4. A circuit as claimed in any preceding claim, characterised in that it comprises a voltage divider circuit having at least two resistors (R1, R2; R11 R12, R21 R22; R11 R12 R13, R21 R22 R23) constituted by respective polycrystal silicon films (45, 46), wherein the or each overlap (23; 13; 33, 34) between the films (45, 46) constituting the at least two resistors (R1, R2; R11 R12, R21 R22; R11 R12 R13, R21 R22 R23) may provide an output divided voltage.

5. A circuit as claimed in claim 4, characterised in that each film (45, 46) constitutes two or more resistors (R11 R12, R21 R22; R11 R12 R13, R21 R22 R23).

6. A circuit as claimed in claim 5, characterised in that the voltage divider circuit has four or more resistors (R11 R12, R21 R22; R11 R12 R13, R21 R22 R23) alternately constituted by the polycrystal silicon films (45, 46) and every second overlap (13; 33, 34) between the films (45, 46) constituting the four resistors (R11 R12, R21 R22, R11 R12 R13, R21 R22 R23) may provide an output divided voltage.

7. A circuit as claimed in any of claims 4 to 6, characterised in that the voltage divider circuit constitutes a ladder resistor circuit.

8. A circuit as claimed in any preceding claim, further comprising a field-effect transistor (1203, 1204), wherein a gate electrode (1204) of the field-effect transistor is constituted by one of the polycrystal silicon films (45, 46).

9. A circuit as claimed in any preceding claim further comprising a condenser (1205, 1206), wherein an electrode (1205, 1206) of the condenser is constituted by one of the polycrystal silicon films (45, 46).

10. A circuit as claimed in any of claims 4 to 7, characterised in that it further comprises:
a reference voltage circuit (901);
a voltage comparison circuit (903) for comparing a reference voltage output from the reference voltage circuit (901) and a divided voltage output from the voltage divider circuit (902); and
an output circuit (904) for outputting a signal indicative of the comparison.
